# EUROPEAN PATENT SPECIFICATION

(11) **EP 1 420 079 B1**
(45) Date of publication and mention of the grant of the patent: **31.05.2006**
(21) Application number: 03255821.5
(22) Date of filing: 17.09.2003
(51) Int. Cl.: C23C 16/452, C23C 16/455, C23C 16/509, H01J 37/32

(54) **Film-forming system and film-forming method**
Schicht bildendes Apparat und Verfahren
Appareil pour la formation de couches minces et procédé d'utilisation correspondant

(30) Priority: 17.09.2002 JP 2002269581
(43) Date of publication of application: 19.05.2004
(73) Proprietor: ANELVA CORPORATION, Fuchu-shi, Tokyo 183-8508 (JP)
(72) Inventor: Kumagai, Akira c/o Anelva Corporation, Fuchu-shi Tokyo 183-8508 (JP)
(74) Representative: Lyndon-Stanford, Edward W.B.

(56) References cited:
- US-A1- 2001 054 382
- US-B1- 6 436 487

## Description

### BACKGROUND OF THE INVENTION

### Field of the Invention

The present invention relates to a film-forming system and a film-forming method using the same. In particular, the present invention relates to a system for forming a film by chemical reaction using active species (radicals) and a method of using the same.

### Description of the Related Art

The known conventional method of producing large liquid crystalline displays include a method of using a high-temperature polysilicon TFT (thin film transistor) and a method of using a low-temperature polysilicon TFT.

In the method of using a high-temperature TFT, a quartz substrate enduring high temperatures of 1000°C or more has been utilized to prepare an oxide film of high quality. In preparation of a low-temperature TFT, on the other hand, a usual glass substrate for TFT is used, and thus the film should be formed in a low-temperature environment (for example 400°C).

The method of using a low-temperature polysilicon TFT to produce a liquid crystalline display has been practically used in recent years because of the advantage of easy determination of film-forming conditions without using a special substrate, and the production thereof is increasing.

When a silicon oxide film suitable as a gate insulation film is to be produced at low temperatures in preparing a liquid crystalline display utilizing a low-temperature polysilicon TFT, plasma CVD is used. When a silicon oxide film is formed by plasma CVD, a typical material gas such as silane or tetraethoxysilane (TEOS) is used.

When a silicon oxide film is formed by Chemical Vapor Deposition (simply referred to as CVD in the present specification) using a material gas such as silane and plasma, in a conventional plasma CVD system, a material gas and a gas such as oxygen are introduced into a space in the front of a substrate, a plasma is generated by a mixed gas comprising a material gas and oxygen, and the substrate is exposed to the plasma, thereby a silicon oxide film is deposited on the surface of the substrate.

Thus, the conventional plasma CVD system is constituted such that the material gas is supplied directly to plasma generated in the plasma CVD system. So that, a silicon oxide film deposited on the substrate is damaged, since high-energy ions incidents into a film deposited on the substrate from the plasma existing in a space in the front of the substrate, thereby a problem of a deterioration in film properties is caused.

Further, in the conventional plasma CVD system, the material gas is introduced directly into the plasma, and thus the material gas reacts vigorously with the plasma to generate particles. This causes the problem of a reduction in yield.

Accordingly, a film-forming system utilizing a remote plasma system has been proposed in the prior art in order to solve the before described problems.

For example, there is a plasma CVD system disclosed in Japanese Patent Application Laid-Open (JP-A) No. 5-21393, a plasma treatment system in JP-A No. 8-167596, and a plasma CVD system in JP-A No. 6-260434 (Japanese Patent No. 2601127).

Among those described above, the plasma CVD system disclosed in JP-A No. 6-260434 (Japanese Patent No. 2601127) is the most effective system for preventing damage caused by high-energy ions incidenting into a silicon oxide film and for inhibiting generation of particles.

This plasma CVD system of JP Patent No. 2601127 has a parallel flat electrode structure constituted such that an intermediate electrode is arranged between a high-frequency electrode and a substrate holder electrode. Thereby, a space between the high-frequency electrode and the substrate holder electrode is divided by the intermediate electrode. This intermediate electrode has penetration holes. A high-frequency electricity is supplied to only a space between the high-frequency electrode and the intermediate electrode, whereby plasma discharge is generated only between the high-frequency electrode and the intermediate electrode. Excited active species and ions generated by the plasma discharge are introduced into the space in the front of the substrate through penetration holes formed in the intermediate electrode.

The high-frequency electrode used in JP Patent No. 2601127 is an electrode in a conventional shower head system, and a plasma generating gas is introduced into a plasma generating space through a plurality of holes formed in a diffusion plate.

Also, in this JP Patent No. 260117, the material gas is introduced into the space in the front of the substrate through a gas introduction tube, an internal space formed in the intermediate electrode, and a diffusion hole (gas diffusion port) formed in the intermediate electrode.

This plasma CVD system disclosed in JP Patent No. 2601127 is constituted such that the space between the high-frequency electrode and the substrate holder electrode is divided by the intermediate electrode, and only the space between the high-frequency electrode and the intermediate electrode is formed as a plasma generating space, and the plasma generating space is made apart from a place where the substrate is arranged.

Further, a CVD system disclosed in JP-A No. 2000-345349 has been proposed. In the above plasma CVD system disclosed in JP Patent No. 2601127, no special consideration was given to the shape of the penetration hole formed in the intermediate electrode, and thus there is a possibility of the reverse diffusion of the material gas into the plasma generating space. But in the CVD system disclosed in JP-A No. 2000-345349, the reverse diffusion is prevented structurally certainly by prescribing the shape of the penetration hole formed in a partition plate corresponding to the intermediate electrode adopted in the plasma CVD system of JP Patent No. 2601127.

According to the film-forming system disclosed in JP-A No. 2000-345349 using a remote plasma system, the substrate is arranged in a region which is apart from the plasma generating space in the film-forming system and in which short-lived charged particles perish and relatively long-lived radicals exist predominantly, while the material gas is supplied to a region near to a region where the substrate is arranged. Radicals generated in the plasma generating space are diffused toward a film-forming treatment space having the substrate arranged therein, and supplied to a space in the front of the substrate.

The film-forming system using a remote plasma system and disclosed in JP-A No. 2000-345349 has the advantage of inhibiting a vigorous reaction between the material gas and plasma thus reducing the amount of particles generated, as well as restricting the incidence of ions into the substrate.

In recent years, there is an increasing demand for higher performance of the device, and when a plasma CVD system is used for meeting with this demand, a silicon oxide film having a high quality as same as that of a thermal oxide film is required.

In any film-forming systems described above, active species formed in the plasma generating space are introduced into the film-forming treatment space where the active species react with the material gas to form a film.

A film-forming system disclosed in JP-A No.2000-345349 comprises a vacuum chamber and an electroconductive partition plate dividing said vacuum chamber into a plasma generating space provided with a high-frequency electrode and a film-forming treatment space provided with a substrate-retaining mechanism for holding a substrate mounted thereon. A gas for generating desired active species by discharge plasma is introduced into the plasma generating space. Said desired active species are supplied to the film-forming treatment space through a plurality of penetration holes formed in the electroconductive partition plate for communicating the plasma generating space with the film-forming treatment space. Said electroconductive partition plate has a internal space separated from the plasma generating space and communicating with the film-forming treatment space via a plurality of material gas diffusion holes. A material gas is introduced from the outside into said internal space and supplied into the film-forming treatment space through a plurality of said material gas diffusion holes. A film is deposited on the substrate by a reaction between said active species and said material gas supplied to said film-forming treatment space.

That is, in the plasma CVD system disclosed in JP-A No. 2000-345349, oxygen is introduced into the plasma generating space, to generate oxygen radicals (which refer to atomic oxygen including oxygen in the ground state) by discharge plasma, and the oxygen radicals and oxygen (this oxygen is in a molecular state unless particularly referred to as radicals) are supplied to the film-forming treatment space via penetration holes arranged in the partition plate, while a silane gas is supplied as the material gas into an internal space formed in the partition plate and supplied to the film-forming treatment space via diffusion holes. When the reaction among these oxygen radicals, oxygen and silane is used to form a silicon oxide film, the vigorous reaction between the material gas such as silane gas and the plasma can be prevented. So that the amount of particles generated is reduced while the incidence of ions onto the substrate is restricted. Therefore a silicon oxide film superior in characteristics to a film formed by conventional plasma CVD system such as disclosed in JP-A No.5-21393 can be obtained.

In formation of a silicon oxide film where a larger glass substrate is required, however, the deposition rate and film properties (electrical characteristics etc.) are in the "tradeoff" relationship. That is, the deposition rate cannot be increased while good film properties are maintained, which is a problem to be solved for productivity.

For example, when a silicon oxide film is formed from a silane (SiH₄) gas by the CVD method, the deposition rate can be increased by a method that involves increasing the flow rate of the silane gas of material gas or increasing the amount of oxygen radicals in the plasma generating space.

However, when the flow rate of the silane gas is increased, it causes inconvenience such as oxygen radicals or an oxygen gas causes a rapid reaction of generating silicon oxide in a gaseous phase (in the film-forming treatment space), so that a generation of particles is caused without forming of a silicon oxide film on a glass substrate.

On the other hand, when the amount of oxygen radicals in the plasma generating space is increased, the absolute amount of oxygen contributable to oxidation in the film-forming treatment space is made insufficient as oxygen radicals are increased. Accordingly, although the deposition rate can be increased, a film is formed in an insufficiently oxidized condition. Therefore, it is impossible to achieve improvements in film properties.

### SUMMARY OF THE INVENTION

To solve the problems described above, the object of the present invention is to provide a film-forming system and film-forming method excellent in productivity capable of improving the relationship between the deposition rate and film properties regarded conventionally as the "tradeoff" relationship. That is to say, the object of the present invention is to provide a film-forming system and film-forming method which can form a silicon oxide film having a good quality with increasing the deposition rate as well as maintaining film properties, and achieve high deposition rate of a silicon oxide film.

First, we describe findings leading to the constitution of the present invention as a means to achieve the above object.

The present inventors made extensive study on formation of a silicon oxide film by using a reaction among oxygen radicals, oxygen and silane in a film-forming treatment space in a conventional system such as the CVD system disclosed in JP-A No. 2000-345349. They revealed that oxygen radicals are important as a trigger of a series of reactions, while oxygen is important for the final reaction of converting silicon monoxide (SiO) into silicon dioxide (SiO₂). That is, they found that both oxygen radicals and oxygen are important for a series of reactions.

Further, the present inventors revealed that oxygen radicals supplied to the film-forming treatment space can be regulated by electricity supplied to a high-frequency electrode or by the pressure in the plasma forming space, and also that film properties are improved as the amount of the oxygen radicals supplied is increased.

From the results of their study, however, the present inventors conceived that in the conventional film-forming system, oxygen radicals are formed by decomposition of oxygen introduced into the plasma generating space, and thus the amount of oxygen supplied to the film-forming treatment space is in the "tradeoff" relationship with the amount of the oxygen radicals formed. And they conceived, even if oxygen radicals supplied to the film-forming treatment space is increased to attain excellent properties of silicon oxide film, oxygen is reduced with the increasing of oxygen radicals, and therefore the amount of oxygen becomes insufficient and not optimum. That is, they found that as the amount of oxygen radicals is increased, film properties can be improved, but the amount of oxygen becomes insufficient, resulting in limitation of the properties.

From the inventors' study, it was revealed that as the amount of the material gas such as silane gas is increased, the film can be deposited at higher rate, but the deposition rate and film properties are in the "tradeoff" relationship so that film properties are lowered as the deposition rate is increased. This is because when film properties are to be maintained in high deposition rate of the film, the amount of oxygen radicals should further be increased, thus the amount of oxygen becomes further insufficient.

From the foregoing, it was found that supplying oxygen radicals sufficiently with supplying oxygen sufficiently is important to achieve film properties of high quality.

On the basis of the finding described above, the film-forming system and method according to the present invention are constituted as follows.

That is, the present invention relates to a system for forming a film by generating plasma in a vacuum chamber to generate active species (radicals) and forming a film on the substrate from a material gas and said active species reacted in the vacuum chamber, and to a method of forming a film by using the same.

The vacuum chamber is provided with an electroconductive partition plate dividing the vacuum chamber into two spaces. One of the two spaces is formed as a plasma generating space provided with a high-frequency electrode, and the other space is formed as a film-forming treatment space provided with a substrate-retaining mechanism for holding a substrate mounted thereon.

The electroconductive partition plate is formed with a plurality of penetration holes for communicating the plasma generating space with the film-forming treatment space. The electroconductive partition plate further has a first internal space separated from the plasma generating space and communicating with the film-forming treatment space via a plurality of material gas diffusion holes.

A material gas is introduced from the outside into the first internal space, and the gas introduced into the first internal space is supplied to the film-forming treatment space through a plurality of the material gas diffusion holes.

A gas for generating desired active species by discharge plasma is introduced into the plasma generating space, and desired active species generated by discharge plasma are supplied to the film-forming treatment space through a plurality of penetration holes formed in the electroconductive partition plate.

In the film-forming treatment space, a film is deposited on the substrate by a reaction between material gas and the active species supplied into the film-forming treatment space.

The thus constituted film-forming system of the present invention is characterized in that the electroconductive partition plate further has a second internal space which is separated from the first internal space, into which a material gas is introduced. Said second internal space communicates with the film-forming treatment space via a plurality of gas diffusion holes. And said second internal space is further structured that a gas other than the material gas is introduced from the outside.

The film-forming system of the present invention in another embodiment is characterized in that the diameter of the penetration holes formed in the electroconductive partition plate is smaller in the side of the plasma generating space than in the side of the film-forming treatment space. And the electroconductive partition plate further has a second internal space which is separated from the first internal space, into which a material gas is introduced. Said second internal space communicates with the penetration holes via gas introduction holes. And, said second internal space is further structured that a gas other than the material gas is introduced from the outside.

According to the film forming system of the present invention, a gas other than the material gas is introduced independently of the material gas via the second internal space into the film-forming treatment space, and the flow rate of a gas other than the material gas can be controlled independently of the flow rate of the material gas, and the desired gas is supplied in a predetermined amount to the film-forming treatment space.

The film-forming system in the before described another embodiment also can achieve the above-described effect, and can further supply the other gas than the material gas efficiently to the film-forming treatment space with preventing the gas introduced into the second internal space from being diffused into the plasma generating space.

In the present invention, a monosilane gas, a disilane gas, a trisilane gas or a tetraethoxysilane gas (TEOS) is preferably used as the material gas. These material gas may be diluted with a diluent gas.

In the present invention, an oxygen gas is preferably introduced into the plasma generating space in order to supply oxygen radicals in a larger amount to the film-forming treatment space.

In the present invention, even if the amount of oxygen radicals is increased, a silicon oxide film can be deposited with maintaining film properties without deficiency in oxygen in the film-forming treatment space. So that, it is preferable to introduce an inert gas such as helium (He), argon (Ar), krypton (Kr) or xenon (Xe), which acts for increasing the efficiency of formation of oxygen radicals, into the plasma generating space.

In the present invention, the gas other than the material gas introduced into the second internal space preferably includes an oxygen gas. This is because the oxygen, the amount of which is insufficient for forming a silicon oxide film in the conventional system, can be supplemented by introducing a gas including an oxygen gas into the second internal space, thus a silicon oxide film of higher quality can be formed.

To control the process of vigorously forming oxide silicon in the gaseous phase (in the film-forming treatment space), an added gas such as an ammonia (NH₃) gas, a nitrogen dioxide (NO₂) gas, an ethylene (C₂H₄) gas or an ethane (C₂H₆) gas or a mixed gas thereof is preferably introduced into the film-forming treatment space. This is because by introducing the added gas such as ammonia into the film-forming treatment space, a chain reaction between the silane gas and oxygen can be effectively inhibited. And even if the flow rate of the material gas such as silane gas is increased for the purpose of increasing the deposition rate, an excessive chain reaction between the radicals and the silane gas etc. can be prevented in the film-forming treatment space, also it can prevent the silicon oxide from being polymerized in a large amount as well as the particles from being generated.

It is possible to use not only a method of supplying the before described added gas by adding it, for example, to an oxygen gas, then introducing the mixed gas into the second internal space and supplying said mixed gas from the second internal space to the film-forming treatment space but also any other methods insofar as the before described added gas can be supplied to the film-forming treatment space.

Preferably the system of the present invention is provided with the flow-rate controller for controlling the flow rate of a gas introduced into the plasma generating space and the flow-rate controller for regulating a gas introduced into the second internal space, the two controllers being capable of being independently regulated. By this constitution, the amounts of oxygen radicals, oxygen, ammonia etc. supplied to the film-forming treatment space can be independently regulated, and oxygen radicals, oxygen, ammonia etc. in the optimum amounts for forming a silicon oxide film of high quality can be introduced into a predetermined place in the film-forming treatment space. That is, the reaction process of forming a silicon oxide film can be regulated, and a silicon oxide film of high quality can be formed. Also, even if the film is deposited at higher rate by increasing the amount of the material gas supplied to the film-forming treatment space, sufficient amounts of oxygen radicals, oxygen, ammonia etc. can be supplied to the film-forming treatment space, so that a film having a silicon oxide's properties of high quality can be formed.

As is clearly explained by the foregoing description, according to the present invention, the electroconductive partition plate is provided with the second internal space which is separated from the first internal space, into which a material gas is introduced, and which communicates with the film-forming treatment space via a plurality of gas diffusion holes. A gas other than the material gas is introduced from the outside into the second internal space. Therefore the gas other than the material gas can, independently of the material gas and a plasma generating gas supplied to the plasma generating space, be introduced into the film-forming treatment space. And the flow rate of the gas other than the material gas can be regulated independently of the flow rate of the plasma generating gas supplied to the plasma generating space and the flow rate of the material gas, and the desired gas other than the material gas can be supplied in a predetermined amount to the film-forming treatment space.

In the present invention, the following constitution of the electroconductive partition plate can be adopted. That is, the diameter of penetration holes formed in the electroconductive partition plate is smaller in the side of the plasma generating space than in the side of the film-forming treatment space. And the second internal space arranged in the electroconductive partition plate communicates with the penetration holes via gas introduction holes. If the supply of the gas other than the material gas via the second internal space to the film-forming treatment space is conducted by using the before described constitution of the electroconductive partition plate, the above-described effect can also be obtained. And it is further possible to supply the other gas than the material gas efficiently to the film-forming treatment space with preventing the gas introduced into the second internal space from being diffused into the plasma forming space.

Further, a gas including an oxygen gas is introduced via the second internal space into the film-forming treatment space, whereby the oxygen, the amount of which is insufficient for deposition of a silicon oxide film in the conventional system and method, can be supplemented. So that, the deposition of a silicon oxide film of higher quality can be achieved.

By adding an added gas such as an ammonia gas, a nitrogen dioxide gas, an ethylene gas, an ethane gas, or a mixed gas thereof, a chain reaction between the silane gas and radicals can be effectively inhibited. So that, even if the flow rate of the material gas such as silane gas is increased for the purpose of increasing the deposition rate, an excessive chain reaction of the radicals with the gas such as silane gas can be prevented in the film-forming treatment space, also it can prevent the silicon oxide from being polymerized in a large amount as well as the particles from being generated.

Further, when the flow-rate controller for controlling the flow rate of a gas introduced into the plasma generating space, the flow-rate controller for regulating a gas introduced into the second internal space and the flow-rate controller for regulating the flow rate of a material gas are arranged and regulating these controllers independently, the amounts of oxygen radicals, oxygen, ammonia etc. supplied to the film-forming treatment space can be independently regulated. So that, oxygen radicals, oxygen, ammonia etc. can be introduced into a predetermined place in the optimum amounts for depositing a silicon oxide film of higher quality. That is, the reaction process of forming the silicon oxide film can be regulated to form a silicon oxide film of high quality. Further, even if the film is deposited at higher rate by increasing the amount of the material gas supplied to the film-forming treatment space, a sufficient amount of oxygen radicals and oxygen, ammonia etc. can be supplied, thus it can deposit a film having film properties of high quality.

### BRIEF DESCRIPTION OF THE DRAWINGS

Fig. 1 is a schematic longitudinal section showing the constitution of a first embodiment of the present invention.
Fig. 2 is a schematic longitudinal section showing the constitution of a second embodiment of the present invention.

### DETAILED DESCRIPTION OF THE INVENTION

Hereinafter, the preferable embodiments of the present invention are described by reference to the accompanying drawings.

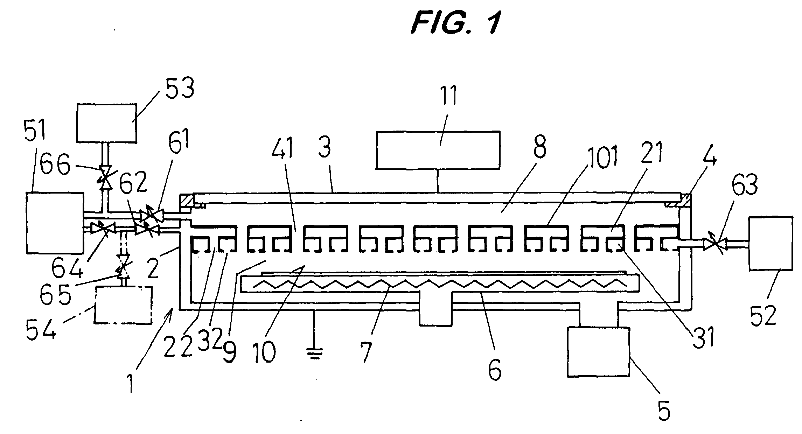

Fig. 1 is an illustration showing the first embodiment of the film-forming system according to the present invention. In this system, it is preferable that a silane gas is used as the material gas, to deposit a silicon oxide film as a gate insulating film on a usual glass substrate for TFT.

In this system, a vacuum chamber 1 is composed of a container 2, an insulating material 4 and a high-frequency electrode 3, and kept in a desired vacuum state by an evaluation mechanism 5. The vacuum chamber 1 is provided therein with electroconductive partition plate 101 made of an electroconductive member. The vacuum chamber 1 is partitioned by the electroconductive partition plate 101 into upper and lower spaces. The upper space forms a plasma generating space 8, and the lower space forms a film-forming treatment space 9.

A gas supply source 51 supplying a gas for generating desired active species by discharge plasma is connected via a flow-rate controller 61 to the plasma generating space 8. An inert gas supply source 53 is connected via a pipe and a flow-rate controller 66 to a space between the gas supply source 51 and the flow-rate controller 61.

The gas used for generating desired active species by discharge plasma is for example an oxygen gas, and the inert gas used is for example a helium gas, an argon gas, a krypton gas or a xenon gas.

A high-frequency power source 11 is connected to the high-frequency electrode 3 arranging in the plasma generating space 8.

A glass substrate 10 to be subjected to film forming treatment is placed on a substrate retaining mechanism 6 arranged in the film-forming treatment space 9, and is arranged opposite to the electroconductive partition plate 101. A heater 7 is arranged in the substrate retaining mechanism 6, to maintain the glass substrate 10 at a predetermined temperature.

The electroconductive partition plate 101 for partitioning the vacuum chamber 1 into two spaces is in a flat shape as a whole with desired thickness. The electroconductive partition plate 101 is provided with a plurality of distributed penetration holes 41, and only via the penetration holes 41, the plasma generating space 8 communicates with the film-forming treatment space 9. The electroconductive partition plate 101 is formed with a first internal space 31 and a second internal space 21 which are separated from each other.

A material gas supply source 52 is connected via a flow-rate controller 63 to the first internal space 31. A silicon gas is used as the material gas, for example.

In the embodiment in Fig. 1, a gas supply source 51 supplying a gas for generating desired active species in the plasma generating space 8 is connected via flow-rate controllers 62 and 64 to the second internal space 21.

As shown in the broken line in Fig. 1, an added-gas supply source 54 is connected via a pipe and a flow-rate controller 65 to a space between the gas supply source 51 and the flow-rate controller 62. The added gas supplied from the added-gas supply source 54 to the second internal space 21 is for example an ammonia gas, a nitrogen dioxide gas, an ethylene gas, an ethane gas, or a mixed gas thereof.

The first internal space 31 and the second internal space 21 are provided with a plurality of material gas diffusion holes 32 and gas diffusion holes 22 respectively. And the first internal space 31 and the second internal space 21 communicate with the film-forming treatment space 9 independently via the material gas diffusion holes 32 and the gas diffusion holes 22 each respectively.

Now, the method of forming a film by the before described film-forming system is described. By a delivery robot, not shown in the drawings, the glass substrate 10 is delivered to the inside of the vacuum chamber 1 and arranged on the substrate-retaining mechanism 6 installed in the film-forming treatment space 9.

The substrate-retaining mechanism 6 is previously maintained at a predetermined temperature thereby heating and keeping the glass substrate 10 at the predetermined temperature.

The vacuum chamber 1 is evacuated by the evacuation mechanism 5 and maintained in a predetermined vacuum state. A gas such as oxygen gas is introduced into the plasma generating space 8 and the second internal space 21 from the gas supply source 51. The flow rate of oxygen gas is regulated independently by the flow-rate controller 61, and the flow-rate controllers 62 and 64 each respectively. The gas such as oxygen gas introduced into the second internal space 21 is supplied to the film-forming treatment space 9 via the gas diffusion holes 22.

On one hand, the flow rate of a material gas such as silane gas is regulated by the flow-rate controller 63 and introduced from the material gas supply source 52 into the first internal space 31. The silane gas introduced into the first internal space 31 is supplied to the film-forming treatment space 9 via the material gas diffusion holes 32.

In this state, the high-frequency electrode 3 is supplied with electricity from the high-frequency power source 11, to generate oxygen plasma in the plasma generating space 8. By generating oxygen plasma, radicals (active species) as neutral excited species are generated.

The long-lived oxygen radicals generated in the plasma generating space 8, together with unexcited oxygen, are supplied to the film-forming treatment space 9 through a plurality of penetration holes 41 provided in the electroconductive partition plate 101. In the plasma generating space 8, charged particles are also generated, but the charged particles are short-lived thus perishing while passing through the penetration holes 41.

The oxygen radicals supplied to the film-forming treatment space 9 react with the silane gas, which supplied through the material gas diffusion holes 32 from the first internal space 31, thus triggering a series of reactions to deposit a silicon oxide film on the glass substrate 10.

During these reactions, an oxygen gas is supplied from the gas supply source 51 via the flow-rate controllers 62 and 64 to the second internal space 21, while oxygen is supplied through the gas diffusion holes 22 from the second internal space 21 into the film-forming treatment space 9. Thus the amounts of oxygen radicals and oxygen supplied to the film-forming treatment space 9 can be independently regulated. And even if the amount of oxygen radicals is increased by regulating discharge electricity etc. to form a silicon oxide film of high quality, sufficient oxygen can be supplied. That is, oxygen rendered insufficient in the reaction of depositing a silicon oxide film in the conventional plasma CVD system can be sufficiently supplied to deposit a silicon oxide film of higher quality than conventional.

To deposit the film at higher rate by increasing the flow rate of the material silane gas, an added gas such as ammonia gas is supplied from the added-gas supply source 54 via the flow-rate controller 65 to the second internal space 21, and the added gas such as ammonia can be supplied from the second internal space 21 via gas diffusion holes 22 to the film-forming treatment space 9.

According to the embodiment of the present invention, even if the film is deposited at higher rate by increasing the flow rate of the material silane gas, oxygen radicals, oxygen, ammonia etc. can be independently regulated and supplied to the film-forming treatment space 9. And thus, sufficient oxygen radicals, oxygen, ammonia etc. in amounts meeting with the amount of the silane gas supplied can be supplied to prevent an excessive chain reaction of the radicals with the silane gas etc. in the film-forming treatment space 9. And simultaneously, silicon oxide can be prevented from being polymerized in a large amount and the characteristics of the silicon oxide film deposited can be maintained.

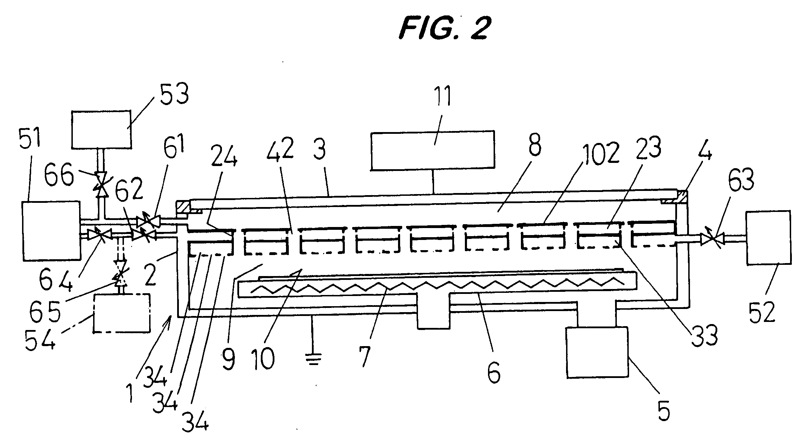

Fig. 2 is an illustration showing the second embodiment of the film forming system according to the present invention, and the same member as in Fig. 1 is given the same symbol. This embodiment is different in the partition plate from the first embodiment. That is, the electroconductive partition plate 102 is formed with a plurality of penetration holes 42 each having a smaller diameter in the side of the plasma generating space 8 than in the side of the film-forming treatment space 9. And the second internal space 23 in the electroconductive partition plate 102, to which a gas such as oxygen gas is supplied, communicates with the penetration holes 42 via gas introduction holes 24.

In this embodiment, a silane gas used as the material gas is supplied from the first internal space 33 through a plurality of material gas diffusion holes 34 to the film-forming treatment space 9.

In this embodiment, a gas such as oxygen gas is supplied from the second internal space 23 via the gas introduction holes 24 to the penetration holes 42. And owing to the shape of the penetration holes 42, the gas such as oxygen gas supplied via the gas introduction holes 24 is prevented from being diffused into the plasma generating space 8, and is thus supplied to the film-forming treatment space 9 efficiently. Accordingly, this embodiment can exhibit an action and effect equal to or higher than in the first embodiment described above.

In the above-described embodiments of the film-forming system and the film-forming method according to the present invention, a silicon oxide film is formed by using a silane gas as the material gas. But the film-forming system and the film-forming method of the present invention are not limited thereto and can be naturally applied to formation of a silicon oxide film by using another material gas such as TEOS.

Further, the present invention can be applied not only to the silicon oxide film but also other films such as silicon nitride film etc. In the above embodiments, a glass substrate is used as the substrate, but the film-forming system and the film-forming method of the present invention are not limited thereto and can be naturally applied to other substrates such as silicon substrate.

As a matter of course, the first internal spaces 31 and 33 and the second internal spaces 21 and 23 may be provided, if necessary, with a diffusion plate to facilitate diffusion of gas.

The preferable embodiments of the present invention have been described by reference to the accompanying drawings, but the present invention is not limited to such embodiments, and can be changed in various modes within the technical scope of the claims.

## Claims

1. A film-forming system comprising a vacuum chamber and an electroconductive partition plate dividing said vacuum chamber into two spaces, one of said two spaces is formed as a plasma generating space provided with a high-frequency electrode and the other space is formed as a film-forming treatment space provided with a substrate-retaining mechanism for holding a substrate mounted thereon;
said electroconductive partition plate is provided with a plurality of penetration holes for communicating the plasma generating space with the film-forming treatment space;
a gas for generating desired active species by discharge plasma is introduced into the plasma generating space;
said desired active species generated in the plasma generating space are supplied to the film-forming treatment space through said plurality of the penetration holes in the electroconductive partition plate;
said electroconductive partition plate has a first internal space separated from the plasma generating space and communicating with the film-forming treatment space via a plurality of material gas diffusion holes;
a material gas is introduced from the outside into said first internal space and supplied into the film-forming treatment space through a plurality of said material gas diffusion holes; and a film is deposited on the substrate by a reaction between said active species and said material gas supplied to said film-forming treatment space;
wherein said electroconductive partition plate further has a second internal space separated from said first internal space and communicating with said film-forming treatment space via a plurality of gas diffusion holes, and a gas other than said material gas is introduced from the outside into said second internal space.

2. A film-forming system comprising a vacuum chamber and an electroconductive partition plate dividing said vacuum chamber into two spaces, one of said two spaces is formed as a plasma generating space provided with a high-frequency electrode and the other space is formed as a film-forming treatment space provided with a substrate-retaining mechanism for holding a substrate mounted thereon;
said electroconductive partition plate is provided with a plurality of penetration holes for communicating the plasma generating space with the film-forming treatment space;
a gas for generating desired active species by discharge plasma is introduced into the plasma generating space;
said desired active species generated in the plasma generating space are supplied to the film-forming treatment space through said plurality of the penetration holes in the electroconductive partition plate;
said electroconductive partition plate has a first internal space separated from the plasma generating space and communicating with the film-forming treatment space via a plurality of material gas diffusion holes;
a material gas is introduced from the outside into said first internal space and supplied into the film-forming treatment space through a plurality of said material gas diffusion holes; and a film is deposited on the substrate by a reaction between said active species and said material gas supplied to said film-forming treatment space;
wherein the size or diameter of said penetration holes is smaller in the side of the plasma generating space than in the side of the film-forming treatment space;
said electroconductive partition plate further has a second internal space separated from said first internal space and communicating with said penetration holes via gas introduction holes, and a gas other than the material gas is introduced from the outside into said second internal space.

3. A film-forming system according to claim 1 or 2, wherein the material gas is a monosilane gas, a disilane gas, a trisilane gas or a tetraethoxysilane gas.

4. A film-forming system according to any of the preceding claims, wherein the gas for generating desired active species by discharge plasma in the side of the plasma generating space includes an oxygen gas.

5. A film-forming system according to any of the preceding claims, wherein the gas for generating desired active species by discharge plasma in the side of the plasma generating space includes an inert gas.

6. A film-forming system according to any of the preceding claims, wherein the gas other than the material gas introduced into the second internal space includes an oxygen gas.

7. A film-forming system according to any of the preceding claims, wherein the gas other than the material gas introduced into the film-forming treatment space includes an added gas comprising any one or combinations selected from an ammonia gas, a nitrogen dioxide gas, an ethane gas and an ethylene gas.

8. A film-forming system according to any of the preceding claims, further comprising a flow-rate controller for controlling the flow rate of a gas for generating desired active species by discharge plasma in the side of the plasma generating space and a flow-rate controller for controlling the flow rate of a gas other than the material gas introduced into the second internal space, both of the flow-rate controllers being able to be independently controlled.

9. A method of forming a film on the substrate by using the film-forming system described in any of the preceding claims.

## Patentansprüche

1. Filmbildungssystem, das eine Vakuumkammer und eine elektrisch leitende Trennwand aufweist, welche die Vakuumkammer in zwei Räume unterteilt, wobei einer der zwei Räume als Plasmaerzeugungsraum ausgebildet und mit einer Hochfrequenzelektrode ausgestattet ist und der andere Raum als Filmbildungsbehandlungsraum ausgebildet und mit einem Substrathaltemechanismus zum Festhalten eines darauf montierten Substrats ausgestattet ist;
wobei die elektrisch leitende Trennwand mit einer Vielzahl von Durchgangslöchern versehen ist, um den Plasmaerzeugungsraum mit dem Filmbildungsbehandlungsraum zu verbinden;
wobei ein Gas zur Erzeugung von gewünschten aktiven Spezies durch Plasmaentladung in den Plasmaerzeugungsraum eingeleitet wird;
wobei die gewünschten, im Plasmaerzeugungsraum erzeugten aktiven Spezies durch die Vielzahl von Durchgangslöchern in der elektrisch leitenden Trennwand dem Filmbildungsbehandlungsraum zugeführt werden;
wobei die elektrisch leitende Trennwand einen ersten Innenraum aufweist, der von dem Plasmaerzeugungsraum getrennt ist und durch eine Vielzahl von Materialgasdiffusionslöchern mit dem Filmbildungsbehandlungsraum in Verbindung steht;
wobei ein Materialgas von außen in den ersten Innenraum eingeleitet und durch eine Vielzahl von Materialgasdiffusionslöchern in den Filmbildungsbehandlungsraum eingespeist wird; und wobei durch eine Reaktion zwischen den aktiven Spezies und dem in den Filmbildungsbehandlungsraum eingespeisten Materialgas eine Film auf dem Substrat abgeschieden wird;
wobei die elektrisch leitende Trennwand ferner einen zweiten Innenraum aufweist, der von dem ersten Innenraum getrennt ist und durch eine Vielzahl von Gasdiffusionslöchern mit dem Filmbildungsbehandlungsraum in Verbindung steht, und wobei ein vom Materialgas verschiedenes Gas von außen in den zweiten Innenraum eingeleitet wird.

2. Filmbildungssystem, das eine Vakuumkammer und eine elektrisch leitende Trennwand aufweist, welche die Vakuumkammer in zwei Räume unterteilt, wobei einer der zwei Räume als Plasmaerzeugungsraum ausgebildet und mit einer Hochfrequenzelektrode ausgestattet ist und der andere Raum als Filmbildungsbehandlungsraum ausgebildet und mit einem Substrathaltemechanismus zum Festhalten eines darauf montierten Substrats ausgestattet ist;
wobei die elektrisch leitende Trennwand mit einer Vielzahl von Durchgangslöchern versehen ist, um den Plasmaerzeugungsraum mit der Filmbildungsbehandlungsraum zu verbinden;
wobei ein Gas zur Erzeugung von gewünschten aktiven Spezies durch Plasmaentladung in den Plasmaerzeugungsraum eingeleitet wird;
wobei die gewünschten, im Plasmaerzeugungsraum erzeugten aktiven Spezies durch die Vielzahl von Durchgangslöchern in der elektrisch leitenden Trennwand dem Filmbildungsbehandlungsraum zugeführt werden;
wobei die elektrisch leitende Trennwand einen ersten Innenraum aufweist, der von dem Plasmaerzeugungsraum getrennt ist und durch eine Vielzahl von Materialgasdiffusionslöchern mit dem Filmbildungsbehandlungsraum in Verbindung steht;
wobei ein Materialgas von außen in den ersten Innenraum eingeleitet und durch eine Vielzahl von Materialgasdiffusionslöchern in den Filmbildungsbehandlungsraum eingespeist wird; und wobei durch eine Reaktion zwischen den aktiven Spezies und dem in den Filmbildungsbehandlungsraum eingespeisten Materialgas eine Film auf dem Substrat abgeschieden wird;
wobei die Größe oder der Durchmesser der Durchgangslöcher in der Seite des Plasmaerzeugungsraums kleiner ist als in der Seite des Filmbildungsbehandlungsraums;
wobei die elektrisch leitende Trennwand ferner einen zweiten Innenraum aufweist, der von dem ersten Innenraum getrennt ist und durch Gaseinleitungslöcher mit den Durchgangslöchern in Verbindung steht, und wobei ein anderes Gas als das Materialgas von außen in den zweiten Innenraum eingeleitet wird.

3. Filmbildungssystem nach Anspruch 1 oder 2, wobei das Materialgas ein Monosilangas, ein Disilangas, ein Trisilangas oder ein Tetraethoxysilangas ist.

4. Filmbildungssystem nach einem der vorangehenden Ansprüche, wobei das Gas zur Erzeugung der gewünschten aktiven Spezies durch Plasmaentladung in der Seite Plasmaerzeugungsraums ein Sauerstoffgas enthält.

5. Filmbildungssystem nach einem der vorangehenden Ansprüche, wobei das Gas zur Erzeugung der gewünschten aktiven Spezies durch Plasmaentladung in der Seite des Plasmaerzeugungsraums ein Inertgas enthält.

6. Filmbildungssystem nach einem der vorangehenden Ansprüche, wobei das in den zweiten Innenraum eingeleitete vom Materialgas verschiedene Gas ein Sauerstoffgas enthält.

7. Filmbildungssystem nach einem der vorangehenden Ansprüche, wobei das in den Filmbildungsbehandlungsraum eingeleitete vom Materialgas verschiedene Gas ein zugesetztes Gas enthält, das ein ausgewähltes Gas aus oder Kombinationen aus Ammoniakgas, Stickstoffdioxidgas, Ethangas und Ethylengas aufweist.

8. Filmbildungssystem nach einem der vorangehenden Ansprüche, das ferner einen Durchflußmengenregler zur Regelung der Durchflußmenge eines Gases zur Erzeugung gewünschter aktiver Spezies durch Plasmaentladung in der Seite des Plasmaerzeugungsraums und einen Durchflußmengenregler zur Regelung der Durchflußmenge eines in den zweiten Innenraum eingeleiteten vom Materialgas verschiedenen Gases aufweist, wobei beide Durchflußmengenregler unabhängig voneinander steuerbar sind.

9. Verfahren zur Bildung eines Films auf dem Substrat unter Verwendung des in einem der vorangehenden Ansprüche beschriebenen Filmbildungssystems.

## Revendications

1. Système de formation de film comprenant une chambre à vide et une plaque de partition électro conductrice divisant ladite chambre à vide en deux espaces, un desdits deux espaces étant formé en tant qu'espace de génération de plasma pourvu d'une électrode haute fréquence et l'autre espace étant formé en tant qu'espace de traitement de formation de film pourvu d'un mécanisme de rétention de substrat en vue de maintenir le substrat sur ce dernier;
ladite plaque de partition électro conductrice étant pourvue d'une pluralité de trous de pénétration pour faire communiquer l'espace de génération de plasma avec l'espace de traitement de formation de film;
un gaz destiné à engendrer les espèces actives désirées par plasma de décharge étant introduit dans l'espace de génération de plasma;
lesdites espèces actives désirées engendrées dans l'espace de génération de plasma étant fournies à l'espace de traitement de formation de film à travers ladite pluralité des trous de pénétration dans la plaque de partition électro conductrice;
ladite plaque de partition électro conductrice ayant un premier espace interne séparé de l'espace de génération de plasma et communiquant avec l'espace de traitement de formation de film par l'intermédiaire d'une pluralité de trous de diffusion de gaz de matériau;
un gaz de matériau étant introduit de l'extérieur dans ledit premier espace interne et étant fourni à l'espace de traitement de formation de film à travers une pluralité desdits trous de diffusion de gaz de matériau; et un film étant déposé sur le substrat par une réaction entre lesdites espèces actives et ledit gaz de matériau fourni audit espace de traitement de formation de film;
dans lequel ladite plaque de partition électro conductrice a en outre un deuxième espace interne séparé dudit premier espace interne et communiquant avec ledit espace de traitement de formation de film par l'intermédiaire d'une pluralité de trous de diffusion de gaz, et dans lequel un gaz autre que ledit gaz de matériau est introduit de l'extérieur dans ledit deuxième espace interne.

2. Système de formation de film comprenant une chambre à vide et une plaque de partition électro conductrice divisant ladite chambre à vide en deux espaces, un desdits deux espaces étant formé en tant qu'espace de génération de plasma pourvu d'une électrode haute fréquence et l'autre espace étant formé en tant qu'espace de traitement de formation de film pourvu d'un mécanisme de rétention de substrat en vue de maintenir le substrat sur ce dernier;
ladite plaque de partition électro conductrice étant pourvue d'une pluralité de trous de pénétration pour faire communiquer l'espace de génération de plasma avec l'espace de traitement de formation de film;
un gaz destiné à engendrer les espèces actives désirées par plasma de décharge étant introduit dans l'espace de génération de plasma;
lesdites espèces actives désirées engendrées dans l'espace de génération de plasma étant fournies à l'espace de traitement de formation de film à travers ladite pluralité des trous de pénétration dans la plaque de partition électro conductrice;
ladite plaque de partition électro conductrice ayant un premier espace interne séparé de l'espace de génération de plasma et communiquant avec l'espace de traitement de formation de film par l'intermédiaire d'une pluralité de trous de diffusion de gaz de matériau;
un gaz de matériau étant introduit de l'extérieur dans ledit premier espace interne et étant fourni à l'espace de traitement de formation de film à travers une pluralité desdits trous de diffusion de gaz de matériau; et un film étant déposé sur le substrat par une réaction entre lesdites espèces actives et ledit gaz de matériau fourni audit espace de traitement de formation de film;
dans lequel la taille ou le diamètre desdits trous de pénétration est plus petite ou plus petit dans le côté de l'espace de génération de plasma que dans le côté de l'espace de traitement de formation de film;
dans lequel ladite plaque de partition électro conductrice a en outre un deuxième espace interne séparée dudit premier espace interne et communiquant avec lesdits trous de pénétration par l'intermédiaire des trous de d'introduction de gaz, et dans lequel un gaz autre que ledit gaz de matériau est introduit de l'extérieur dans ledit deuxième espace interne.

3. Système de formation de film selon la revendication 1 ou 2, dans lequel le gaz de matériau est un monosilane gazeux, un disilane gazeux, un trisilane gazeux ou un tétraéthoxysilane gazeux.

4. Système de formation de film selon l'une quelconque des revendications précédentes, dans lequel le gaz, pour la génération des espèces actives désirées par plasma de décharge dans le côté de l'espace de génération de plasma, comprend un oxygène gazeux.

5. Système de formation de film selon l'une quelconque des revendications précédentes, dans lequel le gaz, pour la génération des espèces actives désirées par plasma de décharge dans le côté de l'espace de génération de plasma, comprend un gaz inerte.

6. Système de formation de film selon l'une quelconque des revendications précédentes, dans lequel le gaz autre que le gaz de matériau introduit dans le deuxième espace interne comprend un oxygène gazeux.

7. Système de formation de film selon l'une quelconque des revendications précédentes, dans lequel le gaz autre que le gaz de matériau introduit dans l'espace de traitement de formation de film inclut un gaz ajouté comprenant l'un quelconque des gaz ou une combinaison des gaz sélectionnés parmi l'ammoniac gazeux, le dioxyde d'azote gazeux, l'éthane gazeux et l'éthylène gazeux.

8. Système de formation de film selon l'une quelconque des revendications précédentes, comprenant en outre un contrôleur de débit d'un gaz pour la génération d'espèces actives désirées par plasma de décharge dans le côté de l'espace de génération de plasma et un contrôleur de débit pour le contrôle du débit d'un gaz autre que le gaz de matériau introduit dans le deuxième espace interne, les deux contrôleurs de débit étant capables d'être contrôlés de manière indépendante.

9. Procédé de formation d'un film sur le substrat par utilisation du système de formation de film décrit dans l'une quelconque des revendications précédentes.
